(19) Europäisches Patentamt
European Patent Office
Office européen des brevets

(11) Veröffentlichungsnummer: **0 234 338**
**A1**

(12) **EUROPÄISCHE PATENTANMELDUNG**

(21) Anmeldenummer: **87101392.6**

(22) Anmeldetag: **02.02.87**

(51) Int. Cl.$^3$: **H 01 B 3/02**
H 05 K 3/46, C 03 C 14/00

(30) Priorität: **13.02.86 US 829371**

(43) Veröffentlichungstag der Anmeldung:
**02.09.87 Patentblatt 87/36**

(84) Benannte Vertragsstaaten:
**DE FR GB**

(71) Anmelder: **W.C. Heraeus GmbH**
**Heraeusstrasse 12 - 14**
**D-6450 Hanau / Main(DE)**

(72) Erfinder: **Liang, Edward C., Dr.**
**128 Overhill Road**
**Upper Derby, PA 19082(US)**

(74) Vertreter: **Heinen, Gerhard, Dr.**
**W.C. Heraeus GmbH Zentralbereich Patente und Lizenzen**
**Heraeusstrasse 12-14**
**D-6450 Hanau(DE)**

(54) **Ein Antrag gemäss Regel 88 EPÜ auf Berichtigung der Beschreibungsseite 22, Zeile 3 liegt vor. Über diesen Antrag wird im Laufe des Verfahrens von der Prüfungsabteilung eine Entscheidung getroffen werden.**

(57) Eine Luft- oder Stickstoffeinbrand-Dielektrikumszusammensetzung aus
35-60% eines Glases,
5-40% einer Oxidformulierung und
10-30% eines organischen Bindemittels
wird beschrieben.

Abbildung 5

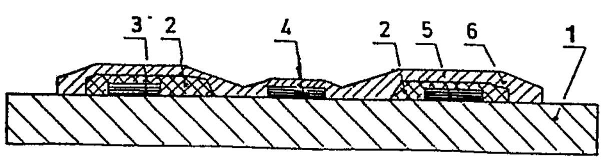


EP 0 234 338 A1

Croydon Printing Company Ltd.

W.C.Heraeus GmbH

Patentanmeldung

# DICKFILM-MEHRSCHICHT-DIELEKTRIKUMSZUSAMMENSETZUNGEN FÜR LUFT- UND STICKSTOFFEINBRAND

Die vorliegende Erfindung bezieht sich auf Dielektrikumszusammensetzungen zur Verwendung in gedruckten Schaltungen.

Insbesondere betrifft die vorliegende Erfindung Dickfilm-Mehrschicht-Dielektrikumssysteme zum Einbrennen an Luft und Stickstoff, die eine Wärmeausdehnung haben, die an die zusammen mit ihnen verwendeten Substrate angepaßt ist.

Dickfilm-Dielektrikums- und Leitermaterialien sind viele Jahre verwendet worden, um keramische Mehrschichtpackungen zu konstruieren. Kürzliche technologische Fortschritte in der Halbleiterindustrie und das Aufkommen der Oberflächenmontagetechnologie haben eine höhere Dickfilmschaltungsdichte auf größeren Substraten verlangt. Dies benötigt eine größere Linienauflösung für Leiterbahnen und eine bessere Auflösung der Durchkontaktierlöcher für Dielektrika. Die Kontrolle der Schaltung ist mit einer Vergrößerung der Fläche schwieriger geworden. Die zweckmäßige Rheologie zum Bedrucken grosser Flächen macht eine Kontrolle der Durchkontaktierlöcher außerordentlich wichtig. Die Kontrolle über zueinander passende Konstruktions- und Druckcharakteristika kann einen großen Einfluß auf die Schaltungsausbeuten und die Langzeitzuverlässigkeit haben.

Da die Mehrschicht-Dickfilmtechnologie in der Mikroelektronikindustrie immer allgemeiner benutzt wird, muß die Auswahl und die Vorbereitung von Rohmaterialien sowie ihre Verarbeitung optimiert werden. Dies hilft, die in der ursprünglichen Konstruktion angestrebten Leistungen zu erzielen. Das Ausbrennen des organischen Bindemittels ist einer der wichtigsten Vorgänge während der Verarbeitung. In dieser Hinsicht bereiten an Luft einbrennbare Dickfilmsysteme die geringsten Probleme. Die Verwendung einer Stickstoffatmosphäre zum Schutz der Kupferleiterbahnen vor Oxidation ergibt jedoch eine

etwas kompliziertere Situation. Für das Entfernen des organischen Bindemittels in Kupfersystemen sind kontrollierte Atmosphären von Stickstoff oder Kombinationen von Gasen untersucht worden.

Bei der Herstellung gedruckter Schaltungen ist es nützlich, wenn man in der Lage ist, dadurch Platz zu sparen, daß man eine Metallisierung direkt über anderen Metallisierungen aufbringt. Um einen Kurzschluß und eine Kapazitätskoppelung zu verhindern, müssen solche Metallisierungen jedoch durch ein dielektrisches Material getrennt werden.

Es gibt zwei Wege, um solche Mehrschichtenstrukturen herzustellen. Der Erste besteht im Druck und Einbrand von "Crossover"-Schichten zwischen den gedruckten Leiterschichten auf einem einzigen Substrat, um das zu bilden, was manchmal eine "mehretagige" gedruckte Schaltung genannt wird. Die zweite Methode beinhaltet das Drucken von Leiterbahnmustern auf organisch gebondete dünne "Bänder" von Aluminiumoxidpartikeln, das nachfolgende Laminieren solcher gedruckter Bänder und das Einbrennen der daraus resultierenden laminierten Struktur bei hoher Temperatur, um eine diskrete, monolithische Mehrschichtstruktur zu erzeugen, die als ihr eigenes Substrat dient.

Eine Crossover-Dielektrikumszusammensetzung ist im wesentlichen ein Isolator mit niedriger Dielektrizitätskonstante, der in der Lage ist, zwei Leiterbahnmuster während des nachfolgenden Einbrennens der Baugruppe zu trennen.

Als Dielektrikum sind hochschmelzende, viskose Gläser verwendet worden, so daß das Einbrennen der oberen Leiterbahn bei einer Temperatur durchgeführt werden kann, die unterhalb der Temperatur liegt, bei der das Dielektrikum erweicht. Ein Schmelzen oder Erweichen des Crossover-Dielektrikums wird von einem Kurzschluß zwischen den zwei Leiterbahnmustern mit einem nachfolgendem Ausfall des elektrischen Schaltkreises begleitet. Die Hauptanforderung an ein Crossover-Dielektrikum ist die Steuerung des Wiedererweichens oder der Thermoplastizität beim Einbrennschritt des oberen Leiters. Weitere Eigenschaftsforderungen sind: (a) Niedrige Dielektrizitätskonstante, um zwischen den Schaltkreisen, die durch das Crossover-Dielektrikum isoliert sind, eine Wechselstromkapazitätskopplung zu verhindern, (b) niedriger Elektrizitätsverlust (hoher Q-Wert), um ein Aufheizen des Dielektrikums zu vermeiden, (c) niedrige Tendenz zur Pinhole-Bildung und eine niedrige Tendenz zur Ausscheidung von Gasen beim Einbrand, (d) eine richtige Erweichungstemperatur der Glasmaterialien, so daß der Eingangseinbrand dem Siebdruckprozeß angepaßt werden kann, (e) eine hohe Resistenz gegen Haarrißbildung bei Thermoschock, (f) geringe Empfindlichkeit gegenüber Wasserdampf und nachfolgende elektrische Streuverluste und (g) ein Wärmeausdehnungskoeffizient, der gut an das Substrat angepaßt ist, z. B. Aluminiumoxid-Substrat, um durch Druck induzierte Rißbildung in Mehrschichtschaltkreisen zu verhindern.

Im U.S.P. 3.848.079 sind die Gläser, welche zum Druck von dielektrischen Crossovers verwendet werden, teilweise kristallisierbar, um in einer Glasmatrix Kristalle zu bilden. In den Anfangsphasen des Einbrennens von partiell kristallisierbaren Dielektrika verhält sich das Dielektrikum, als ob es ein einphasiges Glas sei, und läuft durch die normalen Prozesse des Sinterns, Erweichens und Verschmelzens. Wenn die Anfangseinbrennperiode abgeschlossen ist, erscheinen jedoch Kristalle und verursachen eine große Erhöhung der Viskosität. Beim nachfolgenden Einbrennen erfolgt wenig oder keine Entwicklung einer Thermoplastizität, was gestattet, daß darübergedruckte Metallisierungs- oder Isolierungsschichten sich so verhalten, als ob sie von einem

keramischen Substrat anstelle eines thermoplastischen Glases getragen wären.

U.S.P. 3.848.079 beschreibt ein dichtes, bleifreies Crossover-Dielektrikum, welches zwischen zwei Leitermuster auf einem dielektrischen Substrat gelegt ist. Das Crossover-Dielektrikum besteht im wesentlichen aus 20 - 48% Kristallen in einer glasartigen Matrix. Die Kristalle bestehen im wesentlichen aus Celsian ($BaAl_2Si_2O_8$) als Hauptphase zusätzlich zu geringeren Mengen von Sphen ($CaTiSiO_5$) und Zinkorthosilikat [$(ZnO)_2SiO_2$]. Das Crossover-Dielektrikum ist das eingebrannte Produkt eines bleifreien, kristallisierbaren Glasversatzes, der im wesentlichen etwa aus Folgendem besteht:

25-40% $SiO_2$
5-15% $TiO_2$
7-12% $Al_2O_3$
10-30% BaO
10-26% ZnO
2-10% CaO
2- 8% $B_2O_3$
0- 2% MgO
0- 4% $Bi_2O_3$

Die Gesamtmenge von BaO und ZnO beträgt 30 - 40% des Glasversatzes.

U.S.P. 3.837.869 bezieht sich auf feinverteilte Glasversätze zur Herstellung von Celsian-haltigen dielektrischen Schichten zwischen Leiterbahnmustern, die auf ein Dielektrikumsubstrat gedruckt sind. Solche Dielektrikumsschichten erscheinen zwischen den

Leiterbahnmustern am Punkt ihres Crossovers. Der Glasversatz des U.S.P 3.837.869 enthält zusätzlich zum Glas eine Menge vorgebildeter Celsiankristalle, $BaOxAl_2O_3x2SiO_2$, die eine Erniedrigung der Dielektrizitätskonstante der daraus gebrannten Crossover-Dielektrika bewirkt.

U.S.P.4.152.282 beschreibt eine Dielektrikumspaste, die als Glasphase ein Glas des kurzen, nicht spontan entglasenden Typs und als Keramikphase Aluminiumoxid enthält. Diese Gemische werden als Siebdruckpaste nach Dispersion in einem organischen Bindemittel verwendet. Im Falle eines Mehrschichtauftrages verursachen die nacheinander folgenden Einbrennoperationen in einer Stickstoffatmosphäre kein unerwünschtes Fließen oder eine Verschlechterung der elektrischen Eigenschaften der Schicht.

U.S.P. 4.323.652 offenbart eine Zusammensetzung, die zur Bildung einer Dielektrikumszusammensetzung geeignet ist, die im wesentlichen 85 - 60 Vol.-% einer Glasphase und 15 - 40 Vol.-% einer keramischen Phase enthält, wobei die keramische Phase im wesentlichen aus Zinkoxid oder einem Gemisch von Zinkoxid und Kobaltoxid besteht und die Glasphase die folgende Zusammensetzung in Mol-% hat: 30 - 50% $SiO_2$, 20 - 40% ZnO, 0 - 20% $B_2O_3$, 0 - 10% $Al_2O_3$, 5 - 40% CaO + SrO + BaO und als färbendes Oxid 0 - 10% CaO.

Das britische Patent 1.576.892 betrifft Versätze von feinverteilten anorganischen Pulvern, die für die Bildung dielektrischer Schichten in elektronischen Mehrschichtstrukturen von Leiter- und Dielektrikumsschichten auf einem Aluminiumoxidsubstrat nützlich

sind, wobei der Versatz im wesentlichen in Gew.-% und einander ergänzend enthält:

(a) 65-90% eines oder mehrerer Gläser mit einem Erweichungspunkt oberhalb 700°C und einem Wärmeausdehnungskoeffizienten kleiner als desjenigen von Aluminiumoxid und

(b) 10-35% von kristallinen Füllern, welche, basierend auf dem Gesamtgewicht des Versatzes, bestehen aus

(1) 0-25% $MgTiO_3$ und/oder

(2) 0-35% Gemischen von kristallinen Vormaterialoxiden MgO und $TiO_2$, die in der Lage sind, $MgTiO_3$ zu bilden, vorausgesetzt daß, wenn das Gewicht des $MgTiO_3$ im Versatz kleiner als 10% ist, die relativen Mengenverhältnisse der kristallinen Vormaterialoxide (2) derart sind, daß sich nach dem Einbrennen von Dielektrikumsschichten, die sich aus den Versätzen gebildet haben, in elektronischen Mehrschichtstrukuren eine Gesamtmenge von mindestens 10% $MgTiO_3$ in den eingebrannten Dielektrikumsschichten befindet, und weiter vorausgesetzt, daß die relativen Mengenverhältnisse der kristallinen Vormaterialoxide (2) so sind, daß nach dem Einbrennen von Dielektrikumsschichten, gebildet aus den Versätzen in elektronischen Mehrschichtstrukturen, nicht mehr als 25% $MgTiO_3$ vorhanden sind.

U.S.P. 4.504.339, Kamehara et al., betrifft eine Methode zur Herstellung mehrschichtiger Glas/Keramik-Strukturen mit Leitern auf Kupferbasis. In ihrem Beispiel geben Kamehara et al. die folgende Zusammensetzung:

Zusammensetzung der Glas/Keramik-Paste

| | Komponenten | (Gew.%) |
|---|---|---|
| Glas/Keramik | Pulver | 57,8 |
| Bindemittel | Polymethylmethacrylat | 8,7 |
| Plastiziermittel | Dibutylphthalat | 4,6 |
| Lösungsmittel | Methyläthylketon | 16,1 |
| | Methylalkohol | 8,7 |
| | Butylalkohol | 2,9 |

Zusammensetzung des Glas/Keramik-Pulvers

| Komponenten | (Gew.%) |
|---|---|
| $Al_2O_3$ | 50,5 |
| $SiO_2$ | 35,0 |
| $B_2O_3$ | 13,0 |
| $Na_2O$ | 0,75 |
| $K_2O$ | 0,70 |
| $Li_2O$ | 0,15 |
| CaO | 0,15 |

U.S.P. 4.511.601, Akse et al., betrifft eine Methode zur Herstellung einer Kupfermetallisierung auf dielektrischen Materialien.

Als geeignete Fritten ist in U.S.P. 4.511.601 das Folgende aufgelistet:

Nicht reduzierbare $BaO-B_2O_3-Al_2O_3$-Systeme wie 5 - 65% BaO,

0 - 35% $Al_2O_3$ und 25 - 85% $B_2O_3$, mit bis zu 5% $Na_2O$ oder $K_2O$ für BaO substituiert, bis zu 15% MgO, CaO oder SrO substituiert für BaO, bis zu 50% $SiO_2$ substituiert für $B_2O_3$ und bis zu 5% ZnO, NiO oder CuO substituiert für BaO. Eine bevorzugte Glasfritte in diesem System enthält im wesentlichen 60% BaO, 33,5% $B_2O_3$, 5% $Al_2O_3$ und 1,5% $Na_2O$.

Ein anderes geeignetes, nicht reduzierbares System, das beschrieben wird, ist das $Na_2O$-$B_2O_3$-$SiO_2$-System wie 25 - 55% $B_2O_3$, 0 - 10% $Na_2O$ und 35 - 75% $SiO_2$, mit bis zu 5% $K_2O$ substituiert für $Na_2O$. Eine bevorzugte Fritte in diesem System soll im wesentlichen aus 38,3% $B_2O_3$, 7,7% $Na_2O$ und 54% $SiO_2$ bestehen.

Ein reduktionsresistentes Glassystem, das für die Verwendung in U.S.P. 4.511.061 geeignet sein soll, ist das PbO-$B_2O_3$-$SiO_2$-System, welches Gläser enthält wie 50 - 80% PbO, 15 - 25% $SiO_2$, 15% $B_2O_3$, 0 - 5% $Al_2O_3$, 0 - 5% $Na_2O$ und 0 - 4% $TiO_2$. Eine bevorzugte Zusammensetzung innerhalb dieses Systems soll im wesentlichen 63% PbO, 15,4% $SiO_2$, 15% $B_2O_3$, 0 - 6% $Al_2O_3$, 2% $Na_2O$ und 4% $TiO_2$ enthalten.

Die Dickfilmtechnologie ist seit einiger Zeit von Edelmetallsystemen zu Unedelmetallsystemen fortgeschritten. Die Verwendung von Unedelmetallen wurde nicht nur durch Kostenfaktoren vorangetrieben, sondern auch von Leistungsüberlegungen. Kupferleiter sind zum Beispiel Goldleitern in der Leitfähigkeit und in der Lotakzeptanz überlegen. Kupfer erlaubt eine feinere Liniengestaltung für eine viel höhere Schaltungspackungsdichte und Betrieb bei höherer Geschwindigkeit. Es erlaubt auch die Verwendung der Oberflächenmontagetechnologie zum Aufbringen von Chip-Carriers, Chip-Kondensatoren, Chip-Widerständen etc. Kupfer besitzt elektrolytische Migrations- und Diffusionscharakteristika, die Silber überlegen sind und Legierungen von Silber und Palladium oder Platin vergleichbar sind. Diese Charakteristika sind von lebenswichtiger Bedeutung für die Schaltkreiszuverlässigkeit.

Thermodynamisch ist Kupfer für Oxidation bei erhöhten Temperaturen empfänglich. Stickstoffgas, welches die am allgemeinsten benutzte inerte Atmosphäre für die Behandlung von Kupfer ist, ist für das Entfernen der organischen Bindemittel in den Kupfer- und Dielektrikumspasten nicht sehr wirksam. Anders als Luft als Einbrennatmosphäre oxidiert es nicht, sondern pyrolysiert eher die organischen Bindemittel unter Bildung von Kohlenstoffspezies, die als Reduktionsmittel für die Metalloxide wirken, die in den Dickfilmpastensystemen eingesetzt werden. Die Reduktion kann die elektrische Leistungsfähigkeit verschlechtern und selbst Kurzschlüsse im Schaltkreis verursachen. Ein starker Einbrand solcher Teile kann leicht den Ofen über einen Verdampfungs-Kondensationsprozeß verunreinigen. Dies wird mit einer Erhöhung der Substratgröße und einer Erhöhung der Anzahl der Schichten außerordentlich wichtig. Restkohlenstoff, der aus einem ungenügenden Entfernen der organischen Phase resultiert, kann mit den Kupferoxiden reagieren und Blasenbildung bei Kupfer/Dielektrikumsmehrschichtschaltkreisen verursachen (C.M. Val,

D. Pribat und D. Cotto: "Copper Dielectric Interactions: A Comprehensive Study", Proceedings of the 1980 International Symposium on Microelectronics, pp. 37-48; D.E. Pitkanen und C.J. Speerschneider: "Environmental Effects on Copper Thick Film Microcircuits", IEEE Transactions on Components, Hybrids, and Manufacturing Technology, Vol. CHMT-4, no. 3, pp. 250-256, Sept. 1981). Um die Leistungsfähigkeit von Kupfer nach einem Stickstoffeinbrand zu verbessern, sind Arbeiten betreffs einer Modifikation des Einbrennprozesses, der Ofenkonstruktion und der Einbrennatmosphäre gemacht worden (T.S. Wu, T. Shiramatsu und S.N. Chen: "Improvement of Firing Process in Thick Film Copper Conductor Paste", Proceedings of the 29th Electronic Components Conference, 1979, pp. 11-16; C.Y. Kuo: "Thick Film Copper Conductor Circuits", U.S.P. 4.316.942; P.T. Kitano und D.E. Riemer: "The Nitrogen Furnace in Large-Volume Thick-Film Production", Proceedings of the 1985 International Symposium on Microelectronics, pp. 568-573; J.P. Bradley: "Copper Thick Film Nitrogen Atmosphere Furnace Design and Firing Process Considerations", Proceedings of the 1985 International Symposium on Microelectronics, pp. 435-440; W. Yext, E.A. Hayduk Jr. und C.K. Fisher: "A Study of Various Nitrogen-Based Furnace Atmosphere and Their Effects on Copper Thick Film Conductors and Dielectrics", Proceedings of the 1985 International Symposium on Microelectronics, pp. 583-591).

In einigen Anwendungen, wo die Kosten keinen Faktor darstellen und wo hohe Zuverlässigkeit ein "muß" ist, werden Systeme auf Goldbasis und Palladium/Silberbasis weiterhin verwendet. Eine kürzlich durchgeführte Studie hat gezeigt, daß die meisten kommerziell verfügbaren Stickstoff-Crossoversysteme nicht so zuverlässig sind wie die Palladium/Silber- und Goldsysteme (R.R. Sutherland und I.D.E. Videlo: "A Comparison of the Reliability of Copper and Palladium-Silver Thick-Film Crossovers", Proceedings of the 35th Electronics Components Conference, 1985, pp. 498-504).

Der Wärmeausdehnungskoeffizient (TCE) von Dielektrikumspasten wird sehr wichtig, wenn die Dimensionen des Substrates und die Anzahl der Schichten ansteigen. Die Glaszusammensetzung ist der Schlüssel für die endgültige TCE-Eigenschaft. Eine gut angepaßte Glaszusammensetzung gibt jedoch nicht immer passende dielektrische, elektrische und hermetische Eigenschaften, die für Dickfilmmehrschichtschaltkreisanwendungen benötigt werden. Deshalb werden in den meisten Fällen anorganische Füllstoffe verwendet, um die Glaseigenschaften zu modifizieren. P.S. Turner: "Thermal Expansion Stresses in Reinforced Plastics", J. Res., NBS, 37, 239-250 (1946) schlug eine Beziehung zwischen den Wärmeausdehnungskoeffizienten der zusammengesetzten Verbindung und der Komponenten wie folgt vor:

$$\alpha_r = \frac{\dfrac{\alpha_1 p_1 K_1}{d_1} + \dfrac{\alpha_2 p_2 K_2}{d_2} + \ldots}{\dfrac{p_1 K_1}{d_1} + \dfrac{p_2 K_2}{d_2} + \ldots} \qquad \text{(Gleichung I)}$$

wobei $\alpha_r$ der mittlere Volumenausdehnungskoeffizient und $\alpha_1$ der Volumenausdehnungskoeffizient der Zusammensetzung 1 ist. $K_1$ ist der Massenmodulus der Zusammensetzung 1; $d_1$ ist die Dichte und $p_1$ ist der Gewichtsbruchteil.

Viele der vormaligen Dielektrikumszusammensetzungen verwendeten Blei, Wismut oder Zink. Blei, Wismut oder Zink beeinflussen

beeinflussen jedoch den Einbrand abträglich, besonders den Stickstoffeinbrand.

Die Verwendung von Blei-, Wismut- oder Zinkoxiden kann eine Verunreinigung in dem Tunneleinbrennofen verursachen, in dem Dickfilmmehrschichtschaltkreise verarbeitet werden. Dies wird durch die Natur des hohen Dampfdruckes solcher Oxide verursacht. Zusätzlich kann die Bildung von $ZnSiO_4$ eine schädliche Verbiegung auf Aluminiumoxidsubstraten wegen des im Vergleich zum Wärmeausdehnungskoeffizienten von Aluminiumoxid niedrigen Wärmeausdehnungskoeffizienten von $ZnSiO_4$ verursachen. Demgemäß wäre es vorteilhaft, eine Dielektrikumszusammensetzung mit keinem oder wenig Blei und/oder Wismut zu haben.

Es ist ein Zweck der vorliegenden Erfindung, Dielektrika zu schaffen, die eine an die Substrate angepaßte Wärmeausdehnung haben, um ein Verbiegen zu vermeiden.

Es ist ein anderer Zweck der vorliegenden Erfindung, Dielektrika zu schaffen, die eine optimale Druckbarkeit und eine ausgezeichnete Hermetizität haben, um die Zuverlässigkeit des Schaltkreises sicherzustellen.

Es ist ein weiterer Zweck der vorliegenden Erfindung, Dielektrika mit einer minimalen Durchbiegung in Mehrschichtstrukturen zu schaffen.

Es ist ein weiterer Zweck, Dielektrika zu schaffen, die gute elektrische Leistung, Lötbarkeit, Adhäsionskompatibilität und Widerstandskompatibilität ergeben.

Diese Zwecke und Andere ergeben sich aus der vorliegenden Efindung.

Die vorliegende Erfindung betrifft in Stickstoff und in Luft einbrennbare Dielektrikumszusammensetzungen, bestehend aus (a) einem Glas, (b) einer Oxidformulierung und (c) einem organischen Bindemittel.

Die in Stickstoff einbrennbare dielektrische Zusammensetzung schließt ein:

(a) 35-60% eines Glases oder eines Glasgemisches, basierend auf der Gesamtzusammensetzung, bestehend aus

(1) 10-55% BaO, basierend auf dem Glasgewicht,
(2) 0-20% $Al_2O_3$, basierend auf dem Glasgewicht,
(3) 35-65% $SiO_2$, basierend auf dem Glasgewicht,
(4) 0-10% PbO, basierend auf dem Glasgewicht,
(5) 0-10% $B_2O_3$, basierend auf dem Gladgewicht,
(6) 0-20% CaO, basierend auf dem Glasgewicht,
(7) 0-20% MgO, basierend auf dem Glasgewicht,
(8) 0-20% SrO, basierend auf dem Glasgewicht,
(9) 0-10% $TiO_2$, basierend auf dem Glasgewicht,
(10) 0-10% ZnO, basierend auf dem Glasgewicht,

(11) 0-10% $K_2O$, basierend auf dem Glasgewicht,

(12) 0-10% $Na_2O$, basierend auf dem Glasgewicht,

(13) 0-10% $ZrO_2$, basierend auf dem Glasgewicht

(b) 5-40% einer Oxidformulierung, basierend auf der Gesamtzusammensetzung, bestehend aus:

(1) 0-20% $CaZrO_3$, basierend auf dem Oxidgewicht,

(2) 0-15% $Al_2O_3$, basierend auf dem Oxidgewicht,

(3) 0-15% $TiO_2$, basierend auf dem Oxidgewicht,

(4) 0-15% $SiO_2$, basierend auf dem Oxidgewicht,

(5) 0-15% $ZrO_2$, vorzugsweise $Y_2O_3$-stabilisiertes $ZrO_2$, basierend auf dem Oxidgewicht, und

(c) 10-30% eines organischen Bindemittels, basierend auf der Gesamtzusammensetzung.

Die an Luft einbrennbare dielektrische Zusammensetzung schließt ein:

(a) 35-60% eines Glases, basierend auf der Gesamtzusammensetzung, bestehend aus

(1) 10-55% BaO, basierend auf dem Glasgewicht,

(2) 0-20% $Al_2O_3$, basierend auf dem Glasgewicht,

(3) 35-65% $SiO_2$, basierend auf dem Glasgewicht

(4) 0-10% PbO, basierend auf dem Glasgewicht,

(5) 0-10% $B_2O_3$, basierend auf dem Glasgewicht,

(6) 0-20% CaO, basierend auf dem Glasgewicht,

(7) 0-20% MgO, basierend auf dem Glasgewicht,

(8) 0-20% SrO, basierend auf dem Glasgewicht,

(9) 0-10% $TiO_2$, basierend auf dem Glasgewicht,

(10) 0-10% ZnO, basierend auf dem Glasgewicht,

(11) 0-10% $K_2O$, basierend auf dem Glasgewicht,

(12) 0-10% $Na_2O$, basierend auf dem Glasgewicht,

(13) 0-10% $ZrO_2$, basierend auf dem Glasgewicht,

(b) 5-40% einer Oxidformulierung, basierend auf der Gesamtzusammensetzung, bestehend aus:

(1) 0-20% $CaZrO_3$, basierend auf dem Oxidgewicht,

(2) 0-25% $Al_2O_3$, basierend auf dem Oxidgewicht,

(3) 0-15% $TiO_2$, basierend auf dem Oxidgewicht,

(4) 0-15% $SiO_2$, basierend auf dem Oxidgewicht,

(5) 0-15% $ZrO_2$, vorzugsweise $Y_2O_3$-stabilisiertes $ZrO_2$, basierend auf dem Oxidgewicht, und

(c) 10-30% eines organischen Bindemittels, basierend auf der Gesamtzusammensetzung.

Gemäß der vorliegenden Erfindung ist es möglich, die gleiche Glaszusammensetzung sowohl für Luft- als auch für Stickstoffeinbranddielektrika zu verwenden.

Abbildung 1 ist eine Graphik, die das Einbrennprofil für eine Dielektrikumszusammensetzung für Stickstoffeinbrand gemäß der vorliegenden Erfindung zeigt.

Abbildung 2 ist eine Graphik, die das Einbrennprofil für eine Dielektrikumszusammensetzung für Lufteinbrand gemäß der vorliegenden Erfindung zeigt.

Abbildung 3 ist eine Graphik, die das Durchbiegen einer Dielektrikumszusammensetzung für Stickstoffeinbrand gemäß der vorliegenden Erfindung zeigt.

Abbildung 4 ist eine Graphik, die die Wirkung der Gasgemischkonzentration auf die Verlustfaktoren für zwei Stickstoffeinbranddielektrika der vorliegenden Erfindung zeigt.

Abbildung 5 ist ein Querschnitt einer siebgedruckten Mehrschichtstruktur auf einem Substrat.

Die Gläser (nicht reduzierbaren Gläser) der vorliegenden Erfindung liegen in den Zusammensetzungsbereichen (ausgedrückt in Gewichtsprozent) wie nachfolgend in Tabelle 1 vorgeschrieben vor. Solche Gläser können sowohl für Stickstoff- als auch für Lufteinbranddielektrika gemäß der vorliegenden Erfindung verwendet werden.

Tabelle 1

| Oxid | wirksamer Bereich | bevorzugter Bereich | bevorzugtester Bereich |
|---|---|---|---|
| BaO | 10-55 | 15-50 | 20-45 |
| $Al_2O_3$ | 0-20 | 0-15 | 0-10 |
| $SiO_2$ | 35-65 | 40-60 | 45-55 |
| PbO | 0-10 | 0- 5 | 0- 3 |
| $B_2O_3$ | 0-10 | 0- 5 | 0- 3 |
| CaO | 0-20 | 0-15 | 0-10 |
| MgO | 0-20 | 0-15 | 0-10 |
| SrO | 0-20 | 0-15 | 0-10 |
| $TiO_2$ | 0-10 | 0- 5 | 0- 3 |
| ZnO | 0-10 | 0- 5 | 0- 3 |
| $K_2O$ | 0-10 | 0- 8 | 0- 5 |
| $Na_2O$ | 0-10 | o- 8 | 0- 5 |
| $ZrO_2$ | 0-10 | 0- 5 | 0- 3 |

Ein physikalisches Gemisch der Glasingredienzen (oder ihrer Vorläufer) bildet stabile Gläser, wenn es aus dem geschmolzenen Zustand abgeschreckt wird. Diese stabilen Gläser sind die Gläser der vorliegenden Erfindung. Bei der Herstellung der Gläser der vorliegenden Erfindung werden bestimmte kritische Verhältnisse der Glasbildner angewendet. Wenn die Gläser fein vermahlen, auf Substraten gedruckt und eingebrannt sind, werden eine Keimbildung und eine

teilweise Kristallisation des Glases während des gleichen, relativ einfachen Einbrennverfahrens und demzufolge viel schneller als mit konventionell kristallisierenden Gläsern in einem einzelnen Schritt durchgeführt. Wenn das Glas einmal erweicht und genügend lange Zeit bei der Einbrenntemperatur gehalten wird, um zu kristallisieren, wird es weniger thermoplastisch.

Die Gläser der vorliegenden Erfindung werden aus geeigneten Chargenzusammensetzungen der Oxide (oder der Oxidvorläufer) durch Schmelzen einer jeden geeigneten Chargenzusammensetzung erzeugt, die die vorgeschriebenen Verbindungen in den vorgeschriebenen Anteilen liefert. Metalloxide bilden stabile Gläser, wenn sie aus dem geschmolzenen Zustand abgeschreckt werden, um die Gläser herzustellen. Es kann ein physikalisches Gemisch von Metalloxiden oder Oxidvorläufern wie Metallhydroxiden oder -karbonaten verwendet werden. Die Chargenzusammensetzung, die zur Herstellung der Gläser verwendet werden soll, wird zunächst gemischt und dann geschmolzen, um ein im wesentlichen homogenes,flüssiges Glas zu erzeugen. Die Temperatur während dieses Schmelzschrittes ist nicht kritisch, aber liegt gewöhnlich innerhalb des Bereiches zwischen 1450°-1600°C, so daß eine schnelle Homogenisierung der Schmelze erhalten werden kann. Nachdem ein homogenes,flüssiges Glas erhalten worden ist, wird es generell in Wasser oder eine andere Flüssigkeit gegossen, um eine Glasfritte zu bilden.

Die für die Herstellung von Dielektrika der vorliegenden Erfindung verwendeten Gläser befinden sich in feinverteilter Form. Die obige Glasfritte wird deshalb vor ihrer Dispersion in einem Bindemittel (wenn ja) und vor dem Drucken in einer konventionellen Kugelmühle fein vermahlen. Glaspulver mit einer mittleren Teilchengröße von nicht mehr als 44µm Durchmesser sind allgemein geeignet, aber

solche mit einer mittleren Teilchengröße von 1 - 15µm sind deutlich vorzuziehen. Allgemein sollten keine Teilchen in dieser vorzuziehenden Teilchengröße 44µm überschreiten, d. h. die Teilchen sollten durch ein 325 mesh-Sieb (U.S. Standard Sieve Scale) gehen.

Die Oxidformulierung (nichtleitende Formulierung) für die vorliegende Erfindung liegt innerhalb der Zusammensetzungsbereiche (ausgedrückt in Gewichtsprozent), wie in Tabelle 2 nachfolgend vorgeschrieben:

Tabelle 2

Stickstoffeinbrand

| | wirksam | bevorzugt | meist bevorzugt |
|---|---|---|---|
| $CaZrO_3$ | 0-20 | 0-18 | 0-15 |
| $Al_2O_3$ | 0-15 | 0-13 | 0-10 |
| $TiO_2$ | 0-15 | 0-13 | 0-10 |
| $SiO_2$ | 0-15 | 0-13 | 0-10 |
| $ZrO_2$ | 0-15 | 0-13 | 0-10 |

Lufteinbrand

| | wirksam | bevorzugt | meist bevorzugt |
|---|---|---|---|
| $CaZrO_3$ | 0-20 | 0-18 | 0-15 |
| $Al_2O_3$ | 0-25 | 0-20 | 0-15 |
| $TiO_2$ | 0-15 | 0-13 | 0-10 |
| $SiO_2$ | 0-15 | 0-13 | 0-10 |
| $ZrO_2$ | 0-15 | 0-13 | 0-10 |

$ZrO_2$ in der obigen Tabelle 2 ist vorzugsweise $Y_2O_3$-stabilisiertes $ZrO_2$, z. B. $ZrO_2$x8-12% $Y_2O_3$.

Das organische Bindemittel zur Verwendung in der vorliegenden Erfindung ist eines, das in der Lage ist, mit einem Minimum an Restkohlenstoff ausgebrannt zu werden. Nichteinschränkende Beispiele organischer Bindemittel für die vorliegende Erfindung schließen aliphatische Alkohole, Ester solcher Alkohole, z. B. Acetate und Propionate, die Terpene wie Pine-Öl, alpha- und beta-Terpineol und Ähnliches, Lösungen von Harzen wie die Polymethacrylate niedriger Alkohole oder Lösungen von Äthylcellulose in Lösungsmitteln wie Pine-Öl und die Monobutyläther von Äthylenglykolmonoacetat ein.

Für Stickstoffeinbrandzusammensetzungen ist es vorzuziehen, Butylmethacrylat in einem Lösungsmittel wie "TEXANOL" von Eastman Kodak Co., Rochester, New York, U.S.A., zu verwenden. Für Lufteinbrandzusammensetzungen ist es vorzuziehen, Äthylcellulose in einem Lösungsmittel auf Terpenbasis wie z. B. Pine-Öl zu verwenden.

In der folgenden Tabelle 3 werden Bereiche (ausgedrückt in Gewichtsprozent) für die Komponenten für die Stickstoff- und Lufteinbranddielektrika gemäß der Erfindung gegeben:

Tabelle 3

| | Stickstoffeinbrand | | |
|---|---|---|---|
| Komponente | wirksam | bevorzugt | meist bevorzugt |
| Glas | 30-65 | 35-60 | 40-55 |
| Oxidformulierung | 5-40 | 10-35 | 15-30 |
| Organisches Bindemittel | 5-40 | 10-35 | 15-30 |
| Färbemittel | 0-15 | 1-13 | 1-10 |
| Dispergierungsmittel | 0- 1 | 0,2-0,7 | 0,2-0,5 |

| | Lufteinbrand | | |
|---|---|---|---|
| Komponente | wirksam | bevorzugt | meist bevorzugt |
| Glas | 30-65 | 35-60 | 40-55 |
| Oxidformulierung | 5-40 | 10-35 | 15-30 |
| Organisches Bindemittel | 5-40 | 10-35 | 15-30 |
| Färbemittel | 0-15 | 1-13 | 1-10 |
| Dispergierungsmittel | 0- 1 | 0,2-0,7 | 0,2-0,5 |

In der obigen Tabelle 3 kann das Färbemittel z. B. ein Kobalt-Aluminium-Zinksilikat oder ein Kobaltaluminat sein.

In der obigen Tabelle 3 kann das Dispergierungsmittel z. B. Ölsäure oder ein nicht-ionisches Dispergierungsmittel wie "IGEPAL 430C", GAF Corp., Wayne, New Jersey, U.S.A., sein.

Die Glas-, Oxid- und organischen Bindemittelkomponenten werden gemischt, um eine Paste zu bilden, und auf eine Metallisierung, z. B. eine Kupfermetallisierung für Stickstoffeinbrand, auf einem geeigneten Substrat, z. B. 96% $Al_2O_3$, siebgedruckt.

Vor dem Einbrennen kann das organische Bindemittel 10 - 40% der Siebdruckpaste repräsentieren, wobei das Bindemittel und sein Gewichtsverhältnis in Abhängigkeit von dem gewünschten rheologischen Verhalten ausgewählt ist.

Beim Siebdrucken wird die Paste dann (nachdem sie zu der benötigten Feinheit gemahlen worden ist) durch ein Seidensieb in der Art aufgetragen, daß ein Mehrschichtmuster 2 auf einem Substrat erhalten wird, das typischerweise aus Aluminiumoxid 1 besteht, wie in Abbildung 5 dargestellt. Dieses Muster 2 wird zwischen die unteren Leiter 3, 4 und 5 und einen oberen Leiter 6 gelegt und dient

dazu, den Leiter 6 von den Leitern 3 und 5 zu isolieren, während es wegen des zurückspringenden Teiles 7 ermöglicht wird, eine Verbindung zwischen den Leitern 4 und 5 zu schaffen. Die Elemente 2, 3, 4 und 5 können viele Male wiederholt werden, z. B. bis zu 50 mal.

Die durch dieses Muster erzeugte Schicht wird in einer Stickstoff- oder in einer Luftatmosphäre eingebrannt. Der Stickstoffeinbrand erfolgt in einem Temperaturbereich zwischen 850°C und 950°C, vorzugsweise bei 900°C, mit 5 bis 10 Minuten (Verweilzeit) bei der Spitzentemperatur (siehe Abb. 1). Der Lufteinbrand erfolgt in einem Temperaturbereich von 800°C bis 900°C, vorzugsweise 850°C, mit fünf bis 10 Minuten (Verweilzeit) bei Spitzentemperatur (siehe Abb. 2).

Die Zykluszeit (Durchlaufzeit) sowohl für Luft- als auch für Stickstoffeinbrand beträgt etwa eine Stunde.

Für Stickstoffeinbrand werden Unedelmetall-Leiter, z. B. Nickel, vorzugsweise jedoch Kupfer verwendet. Für lufteinbrennbare Dielektrikumszusammensetzungen werden Leiter aus Edelmetall und Edelmetall-Legierungen verwendet. Nicht einschränkende Beispiele für solche Leiter schließen Gold, Platin, Platin/Gold-Legierungen, Platin/Palladium/Gold-Legierungen, Silber, Palladium/Silber-Legierungen, Palladium/Gold-Legierungen und Platin/Silberlegierungen ein.

Das Substrat für Stickstoff- und Lufteinbranddielektrika kann Aluminiumoxid, Berylliumoxid und Aluminiumnitrid sein.

## Beispiele

**Beispiele 1 bis 19** Glasbereitung

Gläser wurden unter Verwendung von analysenreinen Rohmaterialien in der Oxidform synthetisiert. Wenn die Glaszusammensetzungen formuliert wurden, wurden die einzelnen Komponenten gewogen und eine (1) Stunde in einem V-Mischer homogenisiert (dies ist eine Trockenmischoperation). Nachdem das Mischen beendet war, wurden die homogenisierten Pulver in Aluminiumoxidtiegel gegossen, in welchen sie anschließend geschmolzen wurden. Die Gläser wurden eine (1) Stunde lang bei 600°C vorerhitzt und dann in einen anderen Ofen überführt, in welchem sie typisch im Bereich von 1400°C bis 1600°C 2 bis 4 Stunden lang geschmolzen wurden. Das geschmolzene Material wurde aus dem Ofen bei der Schmelztemperatur entfernt und in rostfreie Stahleimer, die mit entionisiertem Wasser gefüllt waren, gegossen (gefrittet). So wie der Schmelzstrom Kontakt mit dem Wasser bekam, trat eine schnelle Verfestigung und ein Zerfall in Glasstücke ein (Größe diktiert durch thermische Spannungen). Das entionisierte Wasser wurde dekantiert. Das Glas wurde in eine keramische Mühle mit Aluminiumoxidmahlzylindern und einem Isopropylalkoholmedium gebracht. Die Gläser wurden 72 Stunden lang kugelgemahlen und dann durch ein 200 mesh Sieb naß gesiebt. Nach Trocknung in einem explosionsgeschützten Raumtemperatur-Konvektionsofen waren die Pulver zur Charakterisierung und Inkorporierung in Dielektrikumspasten bereit.

Nach dem obigen Verfahren wurden die folgenden Glaszusammensetzungen hergestellt. Die Zahlen in der nachfolgenden Tabelle 4 stellen Gewichtsprozente dar.

Tabelle 4

| Komponente | 1 | 2 | 3 | 4 | 5 | 6 | 7 | 8 | 9 | 10 | 11 | 12 | 13 | 14 | 15 | 16 | 17 | 18 | 19 |
|---|---|---|---|---|---|---|---|---|---|---|---|---|---|---|---|---|---|---|---|
| BaO | 6,66 | 7,06 | | 33,6 | 34,6 | 36,3 | 33,60 | 33,75 | 32,88 | 32,09 | 35 | 25 | 25 | 25 | 33 | 33,22 | 46,00 | 45,00 | 45,00 |
| $Al_2O_3$ | 19.11 | 18,80 | 11 | 9,7 | 10,2 | 10,2 | 8,31 | 7,40 | 8,13 | 7,94 | 8 | 10 | 8 | 8 | 8 | 10,41 | 5,00 | 5,00 | 5,00 |
| $SiO_2$ | 47,01 | 47,26 | 57 | 54,3 | 52,8 | 51,8 | 53,42 | 53,60 | 54,42 | 55,42 | 45 | 45 | 45 | 45 | 50 | 53,40 | 49,00 | 49,00 | 47,00 |
| PbO | - | - | | 1,50 | 0,07 | 0,06 | 1,00 | 1,06 | 0,98 | 0,96 | 3 | 3 | 3 | 1 | - | - | | | |
| $B_2O_3$ | 5,49 | 5,49 | | 0,34 | 0,23 | 0,13 | 0,66 | 1,23 | 0,64 | 0,63 | 1 | 1 | 1 | 1 | 9 | - | | | |
| CaO | 4,93 | 4,83 | | 0,19 | 0,51 | 0,24 | 0,23 | - | - | - | - | 10 | 5 | 5 | | - | | | |
| MgO | 1,78 | 1,66 | | - | 0,32 | 0,25 | - | - | - | - | - | - | 5 | 5 | | - | | | |
| SrO | - | - | 32 | 0,62 | 0,55 | 0,58 | 1,05 | 1,30 | 1,03 | 1,00 | 3 | 1 | 1 | 8 | | 2,21 | | | |
| $TiO_2$ | - | - | | 0,20 | - | - | 0,20 | - | - | - | - | - | - | - | | 0,04 | | | |
| ZnO | 15,02 | 14,90 | | 0,40 | - | - | 0,42 | - | - | - | - | - | - | - | | - | | | |
| $K_2O$ | - | - | | - | - | - | 0,11 | 1,71 | 1,92 | 1,83 | 5 | 5 | 5 | 2 | | 0,08 | | | |
| $Na_2O$ | - | - | | 0,22 | 0,44 | 0,18 | 0,49 | | | | | | | | | 0,35 | | | |
| $ZrO_2$ | | | | 0,16 | 0,16 | 0,16 | | | | | | | | | | | | | |
| $Tg_1$(°C) | 781 | 801 | 841 | 846 | | | 815 | 818 | 826 | 841 | 755 | 775 | 800 | 790 | 758 | 822-877 | | | |
| $Tg_2$(°C) | 865 | 876 | 920 | 935 | | | 900 | 895 | 905 | 905 | 840 | 845 | 865 | 860 | 840 | $\geq$ 1000 | | | |
| TCE(ppm/°C) | 4,0 | 4,0 | 7,0 | 6,0 | | | | 6,3 | 6,3 | 6,0 | 8,2 | 8,0 | 7,5 | 7,2 | 5,4 | 6,0 | | | |

$Tg_1$ = erste (niedrigere) Erweichungstemperatur

$Tg_2$ = zweite (höhere) Erweichungstemperatur

Beispiele 20 bis 26

Die betreffenden Gläser, Oxidkomponenten und organischen Bindemittel (und in einigen Fällen ein Färbemittel) wurden gewogen, um die gewünschten Pastengemische herzustellen. Die Pasten wurden auf eine Mahlfeinheit von <10µm auf dem Walzenstuhl gemahlen.

Dielektrikumstestmuster wurden mit der folgenden Druckdikke siebgedruckt: Naß 30 - 40µm, eingebrannt 15 - 20µm. Die Pasten wurden dann entweder durch ein 200 oder ein 325 mesh-Sieb mit einer 12,5µm -Emulsion gedruckt. Die nassen Drucke wurden vor dem Einbrennen 20 Minuten bei 125°C getrocknet.

Verschiedene Kombinationen der vorerwähnten Gläser (Tabelle 4) wurden mit Oxidkomponenten und organischen Bindemitteln kombiniert, wie nachfolgend in Tabelle 5 zusammengefaßt (die angegebenen Zahlen sind in Gewichtsprozent). "Glas 1" in Tabelle 5 ist das Glas des Beispiels 1. Gleichermaßen ist "Glas 8", Tabelle 5, das Glas des Beispiels 8 und "Glas 13" ist das Glas des Beispiels 13 etc.

Die Beispiele 20 bis 25 sind Stickstoffeinbrand-Dielektrika und Beispiel 26 ist ein Lufteinbrand-Dielektrikum.

Das organische Bindemittel war Polybutylmethacrylat oder Acryloid für die Beispiele 20 bis 25 und Äthylcellulose in Beispiel 26. In einigen Fällen enthielt das Bindemittel auch ein Lösungsmittel wie "TEXANOL", Terpineol oder BCA (Butylcarbitolacetat).

$ZrO_2$ in Tabelle 5 war ein $Y_2O_3$-stabilisiertes $ZrO_2$.

Tabelle 5

| | Beispiel 20 | Beispiel 21 | Beispiel 22 | Beispiel 23 | Beispiel 24 | Beispiel 25 | Beispiel 26 |
|---|---|---|---|---|---|---|---|
| Glas-komponente | Glas 4-6 : 28,02 | Glas 8 : 29,50 | Glas 4-6 : 27,42 | Glas 8 : 30,58 | Glas 13 : 26,64 | Glas 13 : 25,22 | Glas 14 : 49,36 |
| | Glas 1 : 18,68 | Glas 1 : 18,45 | Glas 1 : 18,21 | Glas 1 : 20,38 | Glas 9 : 17,76 | Glas 9 : 16,82 | Glas 1 : 4,2 |
| Gesamtglas | 36,70 | 37,95 | 35,63 | 50,96 | 44,40 | 42,04 | 53,56 |
| Glaszusammensetzung: | | | | | | | |
| BaO | 10,94 | 11,19 | 10,70 | 11,68 | 12,5 | 11,84 | 12,62 |
| $Al_2O_3$ | 6,43 | 5,71 | 6,28 | 6,15 | 3,57 | 3,39 | 4,75 |
| $SiO_2$ | 23,57 | 24,48 | 23,04 | 25,97 | 21,65 | 20,65 | 24,18 |
| PbO | 0,02 | 0,31 | 0,02 | 0,32 | 0,97 | 0,92 | 0,49 |
| $B_2O_3$ | 1,09 | 1,37 | 1,06 | 1,50 | 0,38 | 0,36 | 0,72 |
| CaO | 1,06 | 0,91 | 1,04 | 1,00 | 1,33 | 1,26 | 2,68 |
| MgO | 0,42 | 0,33 | 0,41 | 0,36 | 0,33 | 1,26 | 2,54 |
| SrO | 0,15 | 0,38 | 0,15 | 0,40 | 0,45 | 0,42 | 3,95 |
| ZnO | 2,81 | 2,77 | 2,74 | 3,06 | 0 | 0 | 0,63 |
| $K_2O$ | 0 | 0,50 | 0 | 0,53 | 1,67 | 1,58 | 0,99 |
| $Na_2O$ | 0,12 | 0 | 0,12 | 0 | 0 | 0 | 0 |
| $ZrO_2$ | 0,04 | 0 | 0,04 | 0 | 0 | 0 | 0 |
| Oxidformulierung: | | | | | | | |
| $CaZrO_3$ | 7,00 | | 7,49 | 7,28 | 11,78 | 13,86 | 1,41 |
| $Al_2O_3$ | 5,60 | 9,66 | 6,00 | 5,83 | 3,76 | 5,22 | 12,34 |
| $TiO_2$ | 4,90 | 9,66 | 4,90 | 5,10 | 2,44 | 2,31 | 1,32 |
| $ZrO_2$ | 3,50 | | | 3,64 | 4,67 | 4,39 | |
| Organisches Bindemittel | 32,3 | 32,73 | 31,86 | 27,18 | 25,25 | 32,18 | 28,92 |
| Blaues Färbemittel | | | | | | | 1,96 |
| Dispergiermittel (Ölsäure) | | | | | | | 0,50 |

## Resultate

Die Luft- und Stickstoffeinbrand-Dielektrika der vorliegenden Erfindung können als diejenigen mit der niedrigstmöglichen Dielektrizitätskonstante und dem niedrigstmöglichen Verlustfaktor bezeichnet werden , um maximale Schaltkreisgeschwindigkeit und minimalen Signalverlust zu erlauben. Bei der bezeichneten Druckdicke geben beide Systeme, d. h. Luft und Stickstoff, ausgezeichneten Isolationswiderstand und Durchschlagsspannung für Dickfilmmehrschichtanwendungen. In keinem der dielektrischen Systeme wurde ein Kurzschluß beobachtet. Dies weist darauf hin, daß während des Druckens keine Pinhole-Bildung auftrat. Die elektrische Leistung sowohl des Lufteinbrand-Dielektrikums (Beispiel 26) als auch der Stickstoffeinbrand-Dielektrika sind in den Tabellen 6 und 7 nachfolgend zusammengefaßt, in denen d.f. der Verlustfaktor und IR der Isolationswiderstand ist.

Tabelle 6

Lufteinbrand-Dielektrikumseigenschaften

| K | d.f.(1 KHz) | IR(50-500V Gl.Str.) | Durchschlagsspannung |
|---|---|---|---|
| 7,8 | 0,5% | $1 \times 10^{13}$ Ohm | 500V/25,4µm |

Tabelle 7

Stickstoffeinbrand-Dielektrikumseigenschaften

| | K | d.f.(1 kHz) | IR bei 25V Gl.Str. | Durchschlagsspannung |
|---|---|---|---|---|
| Beisp.24 | 9-10 | 0,5% | $1 \times 10^{13}$ | 500V/25,4µm |
| Beisp.25 | 9-10 | 0,5% | $1 \times 10^{13}$ | 500V/25,4µm |

Die Kapazität der Verlustfaktor und der Isolationswiderstand wurden unter Verwendung eines 7,5mm x 7,5mm Kondensatormusters für die Stickstoffeinbrand-Dielektrika und eines 5mm x 5mm Kondensatormusters für das Lufteinbrand-Dielektrikum getestet (siehe Abb. 2). Die Leiterbahnschichten wurden mit einer gebrannten Filmdicke von 15 µm gedruckt, während die Dielektrikumsschicht unter Verwendung einer Druck-Trocknung-Einbrand-, Druck-Trocknung-Einbrand-Technik bis zu einer Einbrandschichtdicke von 30 bis 35µm gedruckt wurde. Zur Messung der Kapazität und des Verlustfaktors bei einer Frequenz von 1 kHz wurde eine ESI 2110 Videobrücke verwendet. Der Isolationswiderstand wurde mit einem Hewlett-Packard 4329A Hochwiderstands-Meter in einem Spannungsbereich von 50 bis 1000V Gleichstrom gemessen.

Die Zuverlässigkeit von Palladium/Silber- und Kupfercrossvers steht in direktem Bezug zu der Porosität der Dielektrikumsmikrostruktur. Bei einem porösen Dielektrikum unter Bedingungen hoher Luftfeuchtigkeit kann eine Silberwanderung durch das Dielektrikum auftreten, wobei sich zwischen den zwei Leiterschichten Brücken bilden. Obwohl es nicht völlig zu erklären ist, glaubt man, daß eine Kupferwanderung in der gleichen Art stattfinden kann.

Bei der Verwendung des elektrolytischen Immersionstests kann eine offene Porosität in der Dielektrikumsmikrostruktur unter Spannung quantifiziert werden. Eine andere einfache Methode zur Bestimmung des Porositätsgrades ist die Messung der Isolationswiderstandsänderung in einem Wassertropfentest. Die hermetischen Eigenschaften beider Dielektrikumssysteme sind nachfolgend in den Tabellen 8 und 9 zusammengefaßt.

Die Hermetizität wurde mit zwei Methoden gemessen: (1) Wassertropfentest und (2) Leckstromtest. Der Wassertropfentest wurde unter Verwendung eines 7,5mm x 7,5mm quadratischen Testmusters durchgeführt. Der Isolationswiderstand wurde bei 25V Gleichstrom gemessen. Ein Tropfen entionisierten Wassers wurde auf das Dielektrikum gebracht. Der Isolationswiderstand wurde wiederum bei 25V Gleichstrom gemessen. Der Leckstrom wurde mit einem Keithley 617 Elektrometer gemessen. Die Dielektrikumsteile wurden auf eine Dicke von 40-50µm gedruckt. Der gedruckte Leiter diente als Kathode, die unter der Dielektrikumsschicht versenkt ist, während ein Platin-plattiertes Netz als Anode diente. Innerhalb von 24 Stunden nach dem letzten Dielektrikumseinbrand wurden der Testteil und die Anode in eine elektrolytische Zelle gebracht, die 1N NaCl-Lösung als Elektrolyt enthielt. Eine Spannung von 10V Gleichstrom wurde durch die Zelle geleitet. Nach einer Immersionszeit von 5 Minuten wurde der in der Zelle fliessende Strom gemessen.

Tabelle 8

Hermetische Eigenschaften Lufteinbrand

Elektrolytischer Immersionstest

| Leiter | Leckstrom (A/cm² bei 10V) |
|---|---|
| Gold | $3,5 \times 10^{-13}$ |
| Pd/Ag | $9,0 \times 10^{-12}$ |

Wassertropfentest

| Leiter | IR bei 25V Gl.Str. | IR bei 25V Gl.Str. + entionisiertem Wasser |
|---|---|---|
| Gold | $1 \times 10^{13}$ | $1 \times 10^{12}$ |

Das Lufteinbrand-Dielektrikum zeigte bei 10V Gleichstrom einen geringen Leckstrom sowohl bei Gold- als auch bei Palladium/Silberleitern, was darauf hinweist, daß der Palladium/Silberleiter keine meßbare Wanderung zeigte. Beim Wassertropfentest trat nur ein geringer Abfall im Isolationswiderstand auf.

Das hermetische Stickstoffeinbrand-Dielektrikum von Beispiel 24 zeigte ebenfalls einen sehr kleinen Leckstrom, während das TCE-angepaßte Dielektrikum von Beispiel 25 einen relativ kleinen Leckstrom bei 10V Gleichstrom zeigte. Die Leckströme dieser Dielektrika liegen gut unterhalb der Industriespezifikation von 20µA/cm².

Zusätzlich zeigten beide Stickstoffeinbrand-Dielektrika (Beispiele 24 und 25) einen ähnlich geringen Abfall im Isolationswiderstand im Wassertropfentest.

Tabelle 9

Hermetische Eigenschaften Stickstoffeinbrand

Elektrolytischer Immersionstest (Kupferleiter)

| | Leckstrom (A/cm² bei 10V) |
|---|---|
| Beispiel 24 | $1 \times 10^{-10}$ |
| Beispiel 25 | $5 \times 10^{-6}$ |

Wassertropfentest

| | IR bei 25V Gl.Str. | IR bei 25V Gl.Str. + entionisiertem Wasser |
|---|---|---|
| Beispiel 24 | $1 \times 10^{13}$ | $1 \times 10^{12}$ |
| Beispiel 25 | $1 \times 10^{13}$ | $1 \times 10^{12}$ |

Die Stickstoffeinbrand-Dielektrikumspaste von Beispiel 25 wurde auf Coors 96% Aluminiumoxid-Substrate mit einer Druck-Trocknung-Druck-Trocknung-Einbrand-Technik gedruckt. Die Teile wurden,wie in dem Herstellungsabschnitt beschrieben,getrocknet und eingebrannt. Nach jedem Einbrand wurde die Durchbiegung mit einem optischen Mikroskop unter Verwendung eines Okulars gemessen. Die Dicke des Dielektrikums wurde mit einem Mikrometer gemessen.

Die Durchbiegung ist ein Maß für die Unterschiede der Wärmeausdehnungskoeffizienten des Dielektrikums und des Substrats. Wenn man die Proben auf eine ebene Oberfläche plaziert, wird eine positive Durchbiegung definiert als die Wölbung, die man sieht, wenn die Mitte des Substrats höher als die Kanten ist, während ein negatives Durchbiegen als die Wölbung definiert ist, die man sieht, wenn die Kanten höher als die Mitte sind. Wenn ein Dielektrikumsmaterial einen niedrigeren TCE besitzt als den von Aluminiumoxid, verursacht die Schrumpfungsdifferenz beim Abkühlen oft ein positives Durchbiegen und umgekehrt.

Nachdem 25 Einbrände an dem Dielektrikum durchgeführt worden waren, erhielt man nur eine Wölbung von -25µm, wie in Abb.3 zu sehen ist. Dies ist eine ausgezeichnete Anpassung des TCE an 96% Aluminiumoxid. Dies wird als Null-Durchbiegung angesehen, wenn man den experimentellen Fehler aus der optischen Messung berücksichtigt.

Frühere Arbeiten von Yext, Hayduk und Fisher, supra, haben darauf hingewiesen, daß ein zum Stickstoff zugesetztes Gasgemisch für den Ausbrand des Bindemittels hilfreich war, wie durch eine Verbesserung in der elektrischen Leistung des Systems demonstriert wurde.

In jeder Zone wurde dem Stickstoff ein Gasgemisch zugesetzt. Das Gasgemisch wurde in der heißen Zone konstant gehalten und in der Ausbrennzone variiert. Eine Konzentration von 750 ppm des

Gasgemisches wurde der heißen Zone zugesetzt. 2000 ppm und 3000 ppm des Gasgemisches wurden der Ausbrennzone zugegeben. Die Teile wurden unter einer Halbbeladungsbedingung eingebrannt: Vor und hinter den Testteilen ist das Förderband auf einer Gesamtlänge von 50,8 cm vollständig mit Teilen beladen, die völlig mit Dielektrikum bedeckt sind. Außerdem wurden zwei Schichten Dielektrikum auf den Testteilen zusammen eingebrannt.

Die Restkohlenstoffanalyse mittels einer Leco-Technik (siehe Tabelle 10) zeigte eine Abnahme des Kohlenstoffs, sowie die Konzentration des Gasgemisches erhöht wurde. Diese Teile werden mit Teilen, die nur in Stickstoff eingebrannt sind,und mit Lufteinbrand-Dielektrikumsteilen verglichen. Die in Stickstoff eingebrannten Teile gaben die höchsten Werte (81 ppm/g). Die mit 3000 ppm in der Ausbrennzone eingebrannten Teile gaben Resultate, die mit Lufteinbrand-Dielektrika vergleichbar sind (27 ppm/g).

Die REM-Mikrostrukturanalyse demonstriert eine viel porösere Mikrostruktur in Einbränden mit reinem Stickstoff im Vergleich zu Einbränden in Gasgemisch-Stickstoff und Luft. Das Dielektrikum wird dichter, sowie die Konzentration des Gasgemisches ansteigt. Der Dichteanstieg der Mikrostruktur zeigt eine Beziehung zwischen der Porosität und der Konzentration des Restkohlenstoffes.

Tabelle 10

Kohlenstoffanalyse an eingebrannten Dielektrika

| | Dielektrikum | Gasgemischkonzentration Ausbrennzone | Heiße Zone | Kohlenstoff-konzentration |
|---|---|---|---|---|
| Beispiel 24 | $N_2$ | 0 | 0 | 81 ppm/g |
| Beispiel 25 | $N_2$ | 0 | 0 | 81 ppm/g |
| Beispiel 24 | $N_2$ | 2000 | 750 | 47 ppm/g |
| Beispiel 25 | $N_2$ | 3000 | 750 | 27 ppm/g |
| Beispiel 26 | Luft | 0 | 0 | 27 ppm/g |

Die Mikrostruktur des hermetischen Stickstoffeinbrand-Dielektrikums zeigte eine ähnliche Dichte wie die des Lufteinbrand-Dielektrikums. Dies kann durch eine ähnliche Menge von Restkohlenstoff nach dem Einbrand erklärt werden. Daher kann eine optimale Stickstoffeinbrandbedingung in einer minimalen Restkohlenstoffkonzentration und einer dichteren Mikrostruktur resultieren.

Im Verlustfaktor bestand ein abnehmender Trend für ansteigende Gasgemischkonzentrationen für beide Stickstoffeinbrand-Dielektrika. Dieses Phänomen kann wiederum durch geringeren Restkohlenstoff erklärt werden, der aus der höheren Gasgemischkonzentration resultiert (siehe Abb. 5).

Die Dielektrika der vorliegenden Erfindung besitzen auch verbesserte Lötbarkeit und Adhäsionseigenschaften. Weiterhin wird ebenfalls eine verbesserte Golddraht-Bondfestigkeit erhalten.

W.C.Heraeus GmbH

Patentanmeldung

DICKFILM-MEHRSCHICHT-DIELEKTRIKUMSZUSAMMENSETZUNGEN FÜR LUFT- UND STICKSTOFFEINBRAND

PATENTANSPRÜCHE

1. Eine Stickstoffeinbrand-Dielektrikumszusammensetzung, enthaltend:

(a) 35-60% eines Glases, basierend auf der Gesamtzusammensetzung, bestehend aus

(1) 10-55% BaO, basierend auf dem Glasgewicht

(2) 0-20% $Al_2O_3$, basierend auf dem Glasgewicht,

(3) 35-65% $SiO_2$, basierend auf dem Glasgewicht,

(4) 0-10% PbO, basierend auf dem Glasgewicht,

(5) 0-10% $B_2O_3$, basierend auf dem Glasgewicht,

(6) 0-20% CaO, basierend auf dem Glasgewicht,

(7) 0-20% MgO, basierend auf dem Glasgewicht,

(8) 0-20% SrO, basierend auf dem Glasgewicht,

(9) 0-10% $TiO_2$, basierend auf dem Glasgewicht,

(10) 0-10% ZnO, basierend auf dem Glasgewicht

(11) 0-10% $K_2O$, basierend auf dem Glasgewicht,

...

(12) 0-10% $Na_2O$, basierend auf dem Glasgewicht,
(13) 0-10% $ZrO_2$, basierend auf dem Glasgewicht,

(b) 5-40% einer Oxidformulierung, basierend auf der Gesamtzusammensetzung, bestehend aus
(1) 0-20% $CaZrO_3$, basierend auf dem Oxidgewicht,
(2) 0-15% $Al_2O_3$, basierend auf dem Oxidgewicht,
(3) 0-15% $TiO_2$, basierend auf dem Oxidgewicht,
(4) 0-15% $SiO_2$, basierend auf dem Oxidgewicht,
(5) 0-15% $ZrO_2$, basierend auf dem Oxidgewicht, und

(c) 10-30% eines organischen Bindemittels, basierend auf der Gesamtzusammensetzung.

2. Stickstoffeinbrand-Zusammensetzung nach Anspruch 1, dadurch gekennzeichnet, daß der Gewichtsprozentsatz des Glases 35-60% ist.

3. Stickstoffeinbrand-Zusammensetzung nach Anspruch 1, dadurch gekennzeichnet, daß der Gewichtsprozentsatz des Glases 40-55% ist.

4. Stickstoffeinbrand-Zusammensetzung nach Anspruch 1, dadurch gekennzeichnet, daß der Gewichtsprozentsatz der Oxidformulierung 10-35% ist.

5. Stickstoffeinbrand-Zusammensetzung nach Anspruch 1, dadurch gekennzeichnet, daß der Gewichtsprozentsatz der Oxidformulierung 15-30% ist.

6. Stickstoffeinbrand-Zusammensetzung nach Anspruch 1, dadurch gekennzeichnet, daß der Gewichtsprozentsatz des organischen Bindemittels 10-35% ist.

7. Stickstoffeinbrand-Zusammensetzung nach Anspruch 1, dadurch gekennzeichnet, daß der Gewichtsprozentsatz des organischen Bindemittels 15-30% ist.

8. Stickstoffeinbrand-Zusammensetzung nach Anspruch 1, dadurch gekennzeichnet, daß sie weiterhin bis zu 15% eines Färbemittels enthält.

9. Stickstoffeinbrand-Zusammensetzung nach Anspruch 1, dadurch gekennzeichnet, daß das Färbemittel aus der Gruppe bestehend aus einem Kobalt/Aluminium/Zink-Silikat und einem Kobaltaluminat ausgewählt ist.

10. Stickstoffeinbrand-Zusammensetzung nach Anspruch 1, dadurch gekennzeichnet, daß sie weiterhin bis zu 1% eines Dispergiermittels enthält.

11. Stickstoffeinbrand-Zusammensetzung nach Anspruch 1, dadurch gekennzeichnet, daß die Glaszusammensetzung wie folgt ist:

| | |
|---|---|
| BaO | 15-50% |
| $Al_2O_3$ | 0-15% |
| $SiO_2$ | 40-60% |
| PbO | 0- 5% |
| $B_2O_3$ | 0- 5% |
| CaO | 0-15% |
| MgO | 0-15% |
| SrO | 0-15% |
| $TiO_2$ | 0- 5% |
| ZnO | 0- 5% |
| $K_2O$ | 0- 8% |
| $Na_2O$ | 0- 8% |
| $ZrO_2$ | 0- 5% . |

12. Stickstoffeinbrand-Zusammensetzung nach Anspruch 1, dadurch gekennzeichnet, daß die Glaszusammensetzung wie folgt ist:

| | |
|---|---|
| BaO | 20-45% |
| $Al_2O_3$ | 0-10% |
| $SiO_2$ | 45-55% |
| PbO | 0- 3% |
| $B_2O_3$ | 0- 3% |
| CaO | 0-10% |
| MgO | 0-10% |
| SrO | 0-10% |
| $TiO_2$ | 0- 3% |

| | |
|---|---|
| $ZnO$ | 0- 3% |
| $K_2O$ | 0- 5% |
| $Na_2O$ | 0- 5% |
| $ZrO_2$ | 0- 3% . |

13. Stickstoffeinbrand-Zusammensetzung nach Anspruch 1, dadurch gekennzeichnet, daß die Oxidformulierung wie folgt ist:

| | |
|---|---|
| $CaZrO_3$ | 0-18% |
| $Al_2O_3$ | 0-13% |
| $TiO_2$ | 0-13% |
| $SiO_2$ | 0-13% |
| $ZrO_2$ | 0-13% . |

14. Stickstoffeinbrand-Zusammensetzung nach Anspruch 1, dadurch gekennzeichnet, daß die Oxidformulierung wie folgt ist:

| | |
|---|---|
| $CaZrO_3$ | 0-15% |
| $Al_2O_3$ | 0-10% |
| $TiO_2$ | 0-10% |
| $SiO_2$ | 0-10% |
| $ZrO_2$ | 0-10% . |

15. Stickstoffeinbrand-Zusammensetzung nacn Anspruch 1, dadurch gekennzeichnet, daß das $ZrO_2$ $Y_2O_3$-stabilisiertes $ZrO_2$ ist.

16. Eine Lufteinbrand-Dielektrikumszusammensetzung, enthaltend:

(a) 35-60% eines Glases, basierend auf der Gesamtzusammensetzung, bestehend aus

(1) 10-55% BaO, basierend auf dem Glasgewicht,

(2) 0-20% $Al_2O_3$, basierend auf dem Glasgewicht,

(3) 35-65% $SiO_2$, basierend auf dem Glasgewicht,

(4) 0-10% PbO, basierend auf dem Glasgewicht,

(5) 0-10% $B_2O_3$, basierend auf dem Glasgewicht,

(6) 0-20% CaO, basierend auf dem Glasgewicht,

(7) 0-20% MgO, basierend auf dem Glasgewicht,

(8) 0-20% SrO, basierend auf dem Glasgewicht,

(9) 0-10% $TiO_2$, basierend auf dem Glasgewicht,

(10) 0-10% ZnO, basierend auf dem Glasgewicht,

(11) 0-10% $K_2O$, basierend auf dem Glasgewicht,

(12) 0-10% $Na_2O$, basierend auf dem Glasgewicht,

(13) 0-10% $ZrO_2$, basierend auf dem Glasgewicht,

(b) 5-40% einer Oxidformulierung, basierend auf der Gesamtzusammensetzung, bestehend aus

(1) 0-20% $CaZrO_3$, basierend auf dem Oxidgewicht,

(2) 0-15% $Al_2O_3$, basierend auf dem Oxidgewicht,

(3) 0-15% $TiO_2$, basierend auf dem Oxidgewicht,

(4) 0-15% $SiO_2$, basierend auf dem Oxidgewicht,

(5) 0-15% $ZrO_2$, basierend auf dem Oxidgewicht, und

(c) 10-30% eines organischen Bindemittels, basierend auf der Gesamtzusammensetzung.

17. Lufteinbrand-Zusammensetzung nach Anspruch 16, dadurch gekennzeichnet, daß der Gewichtsprozentsatz des Glases 35-60% ist.

18. Lufteinbrand-Zusammensetzung nach Anspruch 16, dadurch gekennzeichnet, daß der Gewichtsprozentsatz des Glases 40-55% ist.

19. Lufteinbrand-Zusammensetzung nach Anspruch 16, dadurch gekennzeichnet, daß der Gewichtsprozentsatz der Oxidformulierung 10-35% ist.

20. Lufteinbrand-Zusammensetzung nach Anspruch 16, dadurch gekennzeichnet, daß der Gewichtsprozentsatz der Oxidformulierung 15-30% ist.

21. Lufteinbrand-Zusammensetzung nach Anspruch 16, dadurch gekennzeichnet, daß der Gewichtsprozentsatz des organischen Bindemittels 10-35% ist.

22. Lufteinbrand-Zusammensetzung nach Anspruch 16, dadurch gekennzeichnet, daß der Gewichtsprozentsatz des organischen Bindemittels 15-30% ist.

23. Lufteinbrand-Zusammensetzung nach Anspruch 16, dadurch gekennzeichnet, daß sie weiterhin bis zu 15% eines Färbemittels enthält.

24. Lufteinbrand-Zusammensetzung nach Anspruch 16, dadurch gekennzeichnet, daß das Färbemittel aus der Gruppe bestehend aus einem Kobalt/Aluminium/Zink-Silikat und einem Kobaltaluminat ausgewählt ist.

25. Lufteinbrand-Zusammensetzung nach Anspruch 16, dadurch gekennzeichnet, daß sie weiterhin bis zu 1% eines Dispergiermittels enthält.

26. Lufteinbrand-Zusammensetzung nach Anspruch 16, dadurch gekennzeichnet, daß die Glaszusammensetzung wie folgt ist:

| | |
|---|---|
| BaO | 15-50% |
| $Al_2O_3$ | 0-15% |

| | |
|---|---|
| $SiO_2$ | 40-60% |
| PbO | 0- 5% |
| $B_2O_3$ | 0- 5% |
| CaO | 0-15% |
| MgO | 0-15% |
| SrO | 0-15% |
| $TiO_2$ | 0- 5% |
| ZnO | 0- 5% |
| $K_2O$ | 0- 8% |
| $Na_2O$ | 0- 8% |
| $ZrO_2$ | 0- 5% . |

27. Lufteinbrand-Zusammensetzung nach Anspruch 16, dadurch gekennzeichnet, daß die Glaszusammensetzung wie folgt ist:

| | |
|---|---|
| BaO | 20-45% |
| $Al_2O_3$ | 0-10% |
| $SiO_2$ | 45-55% |
| PbO | 0- 3% |
| $B_2O_3$ | 0- 3% |
| CaO | 0-10% |
| MgO | 0-10% |
| SrO | 0-10% |
| $TiO_2$ | 0- 3% |
| ZnO | 0- 3% |
| $K_2O$ | 0- 5% |
| $Na_2O$ | 0- 5% |
| $ZrO_2$ | 0- 3% . |

28. Lufteinbrand-Zusammensetzung nach Anspruch 16, dadurch gekennzeichnet, daß die Oxidformulierung wie folgt ist:

| | |
|---|---|
| $CaZrO_3$ | 0-18% |
| $Al_2O_3$ | 0-20% |
| $TiO_2$ | 0-13% |
| $SiO_2$ | 0-13% |
| $ZrO_2$ | 0-13% . |

29. Lufteinbrand-Zusammensetzung nach Anspruch 16, dadurch gekennzeichnet, daß die Oxidformulierung wie folgt ist:

| | |
|---|---|
| $CaZrO_3$ | 0-15% |
| $Al_2O_3$ | 0-15% |
| $TiO_2$ | 0-10% |
| $SiO_2$ | 0-10% |
| $ZrO_2$ | 0-10% . |

30. Lufteinbrand-Zusammensetzung nach Anspruch 16, dadurch gekennzeichnet, daß das $ZrO_2$ $Y_2O_3$-stabilisiertes $ZrO_2$ ist.

31. Eine Glaszusammensetzung für eine Luft- oder Stickstoffeinbrand-Dielektrikumszusammensetzung, bestehend aus

(1) 10-55% BaO, basierend auf dem Glasgewicht,

(2) 0-20% $Al_2O_3$, basierend auf dem Glasgewicht,

(3) 35-65% $SiO_2$, basierend auf dem Glasgewicht,

(4) 0-10% PbO, basierend auf dem Glasgewicht,
(5) 0-10% $B_2O_3$, basierend auf dem Glasgewicht,
(6) 0-20% CaO, basierend auf dem Glasgewicht,
(7) 0-20% MgO, basierend auf dem Glasgewicht,
(8) 0-20% SrO, basierend auf dem Glasgewicht,
(9) 0-10% $TiO_2$, basierend auf dem Glasgewicht,
(10) 0-10% ZnO, basierend auf dem Glasgewicht,
(11) 0-10% $K_2O$, basierend auf dem Glasgewicht,
(12) 0-10% $Na_2O$, basierend auf dem Glasgewicht,
(13) 0-10% $ZrO_2$, basierend auf dem Glasgewicht .

W. C. Heraeus
GmbH
D-6450 Hanau 1

Heraeusstraße 12-14
Postfach 1553
Telefon (06181) 35-1

Heraeus

0234338

Unser Zeichen:
ZPL/Dr.Hn/gr/1290B
Bearbeiter: Dr. Heinen
Telefon (06181) 35-602
Telex 415 202-39 hu d
Telefax 3/a, (06181) 3 35 9
Datum 21.04.1987

Einschreiben

Europäisches Patentamt
Erhardtstraße 27

8000 München 2

EPA EPO-OEB
DG 1
Reçu
01 MAY 1987

Europäische Patentanmeldung 87 101 392.6
"Dickfilm-Mehrschicht-Dielektrikumgszusammensetzungen für Luft- und Stickstoffeinbrand"

Ferner wird eine neue Seite 22 (3-fach) überreicht; in der dritten Zeile von oben mußte ein Schreibfehler korrigiert werden. Anstelle von "4 und 5" muß es korrekterweise "4 und 6" lauten. Es wird gebeten, die urspüngliche Seite 22 durch die neue Seite 22 zu ersetzen.

W.C. Heraeus GmbH
Allg.-Vollmacht 2906

(Dr. Heinen)
(Patentanwalt)

Anlage
Zeichnungen (3-fach)
Seite 22 (3-fach)

0234338

Neu eingereicht / Newly filed
Nouvellement déposé

Abbildung 1

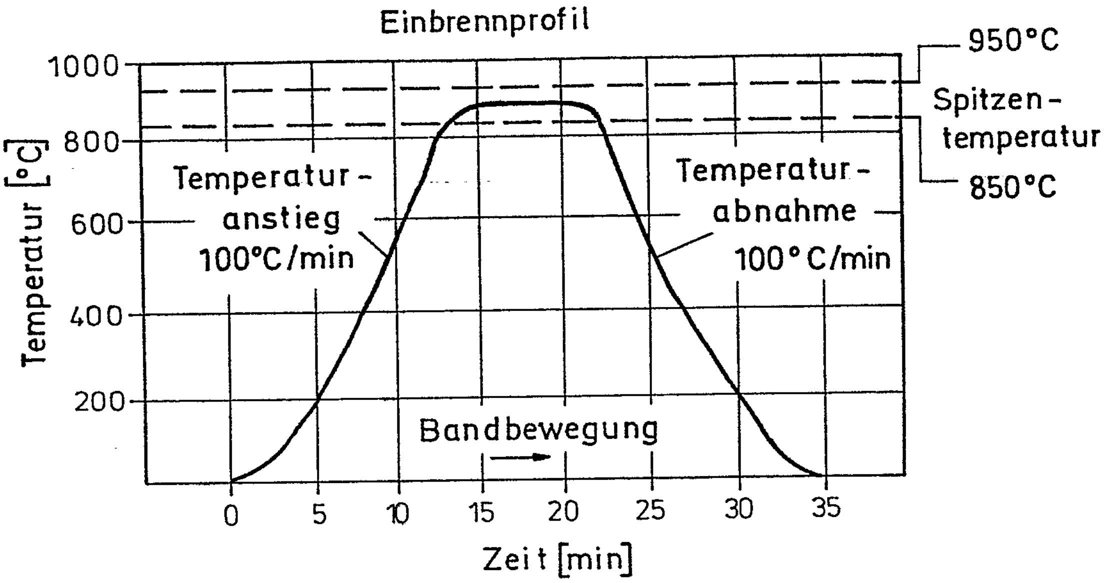


Abbildung 2

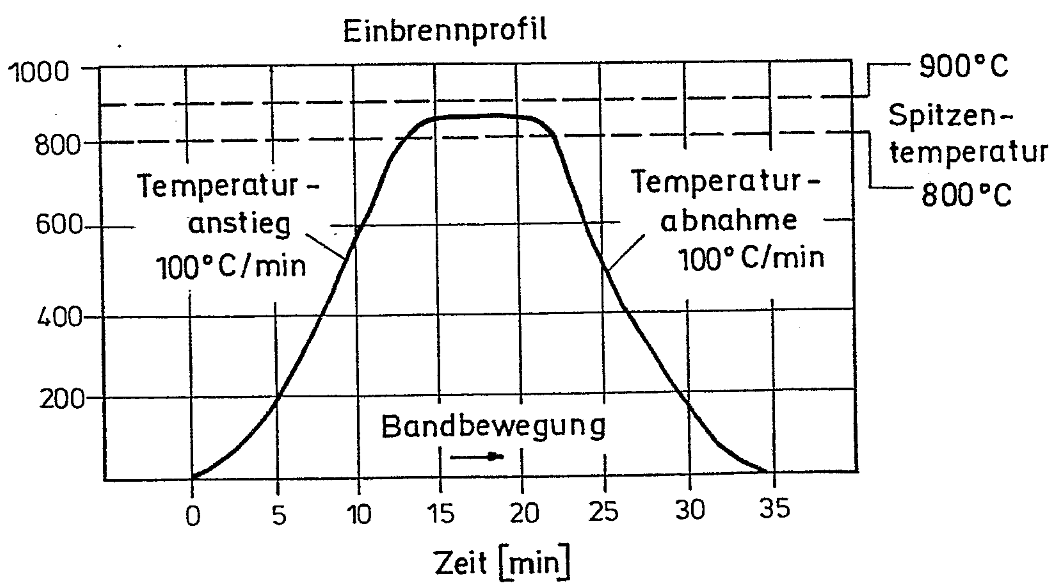

Neu eingereicht / Newly filed
Nouvellement déposé



Abbildung 3

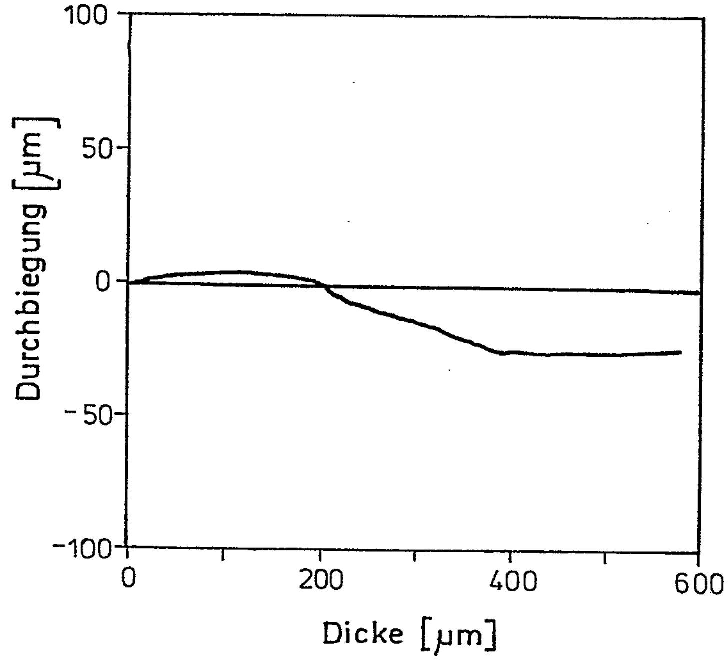


Abbildung 4

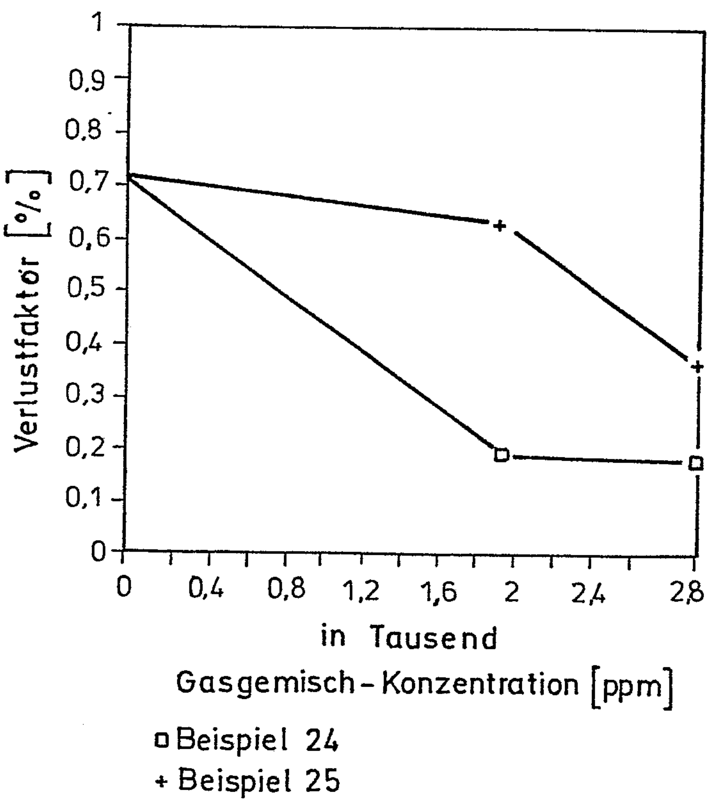

Neu eingereicht / Newly filed
Nouvellement déposé

Abbildung 5

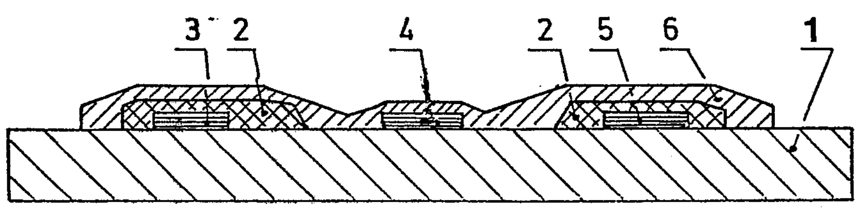

Europäisches Patentamt

**EUROPÄISCHER TEILRECHERCHENBERICHT,**
der nach Regel 45 des Europäischen Patent-übereinkommens für das weitere Verfahren als europäischer Recherchenbericht gilt

Nummer der Anmeldung 0234338

EP 87101392.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | GB - A - 1 559 723 (DU PONT)<br>* Seite 4, Zeilen 55-93; Beispiele 7,A,C,10,J, 14, K,20,28 *<br>-- | 31 | H 01 B 3/02<br>H 05 K 3/46<br>C 03 C 14/00 |
| D,X | GB - A - 1 576 892 (DU PONT)<br>* Seite 4, Zeilen 69-106 *<br>-- | 31 | |
| D,X | US - A - 3 848 079 (AMIN)<br>* Tabellen I,II *<br>---- | 31 | |

RECHERCHIERTE SACHGEBIETE (Int. Cl.4)

H 01 B 3/00
H 05 K 3/00
C 03 C

## UNVOLLSTÄNDIGE RECHERCHE

Nach Auffassung der Recherchenabteilung entspricht die vorliegende europäische Patentanmeldung den Vorschriften des Europäischen Patentübereinkommens so wenig, daß es nicht möglich ist, auf der Grundlage einiger Patentansprüche sinnvolle Ermittlungen über den Stand der Technik durchzuführen.

Vollständig recherchierte Patentansprüche: 31
Unvollständig recherchierte Patentansprüche: –
Nicht recherchierte Patentansprüche: 1–30
Grund für die Beschränkung der Recherche:

Gemäß Merkmal b) der Ansprüche 1 und 16 soll die Zusammensetzung eine Oxidformulierung enthalten, bestehend aus Oxiden, die jedoch nur im Ausmaß von höchstens 80 %, basierend auf dem Oxidgewicht, angegeben sind. Außerdem stehen die Ansprüche 6 und 21 im Widerspruch zu Merkmal c) des Anspruches 1 bzw. 16.

| Recherchenort | Abschlußdatum der Recherche | Prüfer |
|---|---|---|
| WIEN | 29-04-1987 | KUTZELNIGG |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument
& : Mitglied der gleichen Patentfamilie, übereinstimmendes Dokument